# EUROPEAN PATENT APPLICATION

(11) **EP 3 971 945 A1**
(43) Date of publication of application: **23.03.2022**
(21) Application number: 20933278.2
(22) Date of filing: 20.11.2020
(51) Int. Cl.: H01L 21/027, H01L 21/308, H01L 27/108

(54) **SEMICONDUCTOR STRUCTURE AND METHOD FOR FORMING SAME**

(30) Priority: 30.04.2020 CN 202010361178
(71) Applicant: Changxin Memory Technologies, Inc., Hefei, Anhui 230601 (CN)
(72) Inventor: ZHOU, Zhen, Hefei, Anhui 230601 (CN)
(74) Representative: Lavoix
(86) International application number: PCT/CN2020/130380
(87) International publication number: WO 2021/218125

(57) **Abstract**

The present invention relates to the technical field of semiconductors. Disclosed is a semiconductor structure and a method for forming same. The method comprises: providing a substrate, forming a first mask layer on the substrate, and forming several strip-shaped first patterns arranged in parallel in the first mask layer; forming a second mask layer on the first mask layer, and forming several strip-shaped second patterns arranged in parallel in the second mask layer; forming a third mask layer on the second mask layer, and forming several strip-shaped third patterns arranged in parallel in the third mask layer, wherein the second patterns overlap the third patterns, and the second patterns and the third patterns are used for segmenting the first patterns at predetermined positions; and taking the first mask layer, the second mask layer, and the third mask layer as masks, performing etching layer by layer to the substrate, and transferring the first patterns, the second patterns and the third patterns into the substrate to form several discrete active areas arranged in array.

## Description

### CROSS-REFERENCE TO RELATED APPLICATION

This application claims priority to Chinese Patent Application No.: 202010361178.4, filed on April 30, 2020, which is hereby incorporated herein by reference in its entirety.

### TECHNICAL FIELD

The present disclosure relates to the field of semiconductor technology, and specifically, to a semiconductor structure and a manufacturing method thereof.

### BACKGROUND

Dynamic random access memories are semiconductor memories widely used in modern intelligent systems. As the feature size of a semiconductor integrated circuit continues to decrease, the critical size of the dynamic random access memory gradually approaches the physical limit of optical photolithography, which poses a severe challenge to semiconductor manufacturing technology.

A storage unit in a storage array of the memories is formed on an active area. As the storage density increases, the size of the array of active areas becomes smaller. Due to the limitation of technologies such as photolithography and etching, it is becoming more difficult to form the active areas in array arrangement. Therefore, how to form the small-sized discrete active areas in array arrangement by using semiconductor technology to improve the yield of memories is an urgent technical problem to be resolved.

### SUMMARY

The objective of the present disclosure is to provide a semiconductor structure and a manufacturing method thereof, to alleviate the problems in the existing process of manufacturing the small-sized discrete active areas in an array arrangement.

One aspect of the present invention provides a semiconductor structure manufacturing method. The method includes: providing a substrate, in which a first mask layer is formed on the substrate, a plurality of strip-shaped first patterns arranged in parallel are formed in the first mask layer and are configured to form a plurality of strip-shaped continuous active areas arranged in parallel in the substrate; forming a second mask layer on the first mask layer, in which a plurality of strip-shaped second patterns arranged in parallel are formed in the second mask layer; forming a third mask layer on the second mask layer, in which a plurality of strip-shaped third patterns arranged in parallel are formed in the third mask layer, and the second patterns and the third patterns overlap and are configured to cut the first patterns at predetermined positions; and performing layer-by-layer etching, using the first mask layer, the second mask layer, and the third mask layer as masks, to transfer the first patterns, the second patterns, and the third patterns to the substrate to form a plurality of discrete active areas in an array arrangement.

Optionally, forming the second mask layer on the first mask layer may, in which a plurality of strip-shaped second patterns arranged in parallel are formed, includes: forming a first sacrificial layer on the first mask layer, in which the a plurality of strip-shaped fourth patterns arranged in parallel are formed in the first sacrificial layer; forming a mask material on the sidewall of the fourth patterns; and removing the first sacrificial layer while retaining the mask material on the sidewall of the fourth patterns to form the second mask layer.

Optionally, forming a third mask layer on the second mask layer, in which a plurality of strip-shaped third patterns arranged in parallel are formed, includes: forming a second sacrificial layer on the second mask layer, in which a plurality of strip-shaped fifth patterns arranged in parallel are formed in the second sacrificial layer; forming a mask material on the sidewall of the fifth patterns; and removing the second sacrificial layer while retaining the mask material on the sidewall of the fifth patterns to form the third mask layer.

Optionally, an angle between the second patterns and the first patterns is in a range of 65 degrees to 75 degrees.

Optionally, an angle between the second patterns and the third patterns is 90 degrees.

Optionally, a pitch between the fourth patterns arranged in parallel is 4 to 5 times of a pitch between the first patterns arranged in parallel, and a pitch between the fifth patterns arranged in parallel is 4 to 5 times of the pitch between the plurality of first patterns arranged in parallel.

Optionally, an angle between the second patterns and the third patterns is in a range of 45 degrees to 55 degrees.

Optionally, a pitch between the fourth patterns arranged in parallel is 4 to 5 times of a pitch between the first patterns arranged in parallel, and a pitch between the fifth patterns arranged in parallel is 3 to 4 times of the pitch between the first patterns arranged in parallel.

Optionally, the second patterns and the third patterns are configured to cut the first patterns at predetermined positions by a step which includes utilizing an overlap area of the second patterns and the third patterns to cut the first patterns.

Optionally, the second patterns and the third patterns are configured to cut the first patterns at predetermined positions by steps which comprise: forming a second complementary mask layer by utilizing the second patterns in the second mask layer, in which, the second complementary patterns covering an area outside the second patterns are formed in the second complementary mask layer; forming a third complementary mask layer by utilizing the second patterns in the third mask layer, in which the third complementary patterns covering an area outside the third patterns are formed in the third complementary mask layer; and cutting the first patterns by utilizing a non-overlapping area of the second complementary patterns and the third complementary patterns.

Optionally, the substrate includes an array area. The first patterns, the second patterns, and the third patterns are all formed at least in the array area.

Optionally, the method further includes: forming a fourth mask layer on the third mask layer in which sixth patterns covering at least a portion of the second patterns and at least a portion of the third patterns at the edge of the array area is formed in the fourth mask layer.

Optionally, the sixth patterns further covers at least secondary active areas at the ends of the continuous active areas at an edge of the array area, in which the secondary active areas have a length less than that of the discrete active areas. The first patterns, the second patterns, the third patterns, and the sixth patterns are transferred to the substrate to form the discrete active areas in an array arrangement by using the first mask layer, the second mask layer, the third mask layer and the fourth mask layer as masks, in which the secondary active areas are not provided at the edge of the array area.

Optionally, the first patterns may be formed by using a self-aligned double patterning technology.

Optionally, the array area is a storage array area of a dynamic random access memory.

Optionally a material of the mask layers comprises at least one of silicon dioxide, silicon nitride, silicon oxynitride, polycrystalline silicon, monocrystalline silicon and carbon.

Another aspect of the present disclosure provides a semiconductor structure. The semiconductor structure includes a semiconductor substrate, in which discrete active areas in an array arrangement are formed in the semiconductor substrate based on the forgoing semiconductor structure manufacturing method.

The present disclosure has the following advantages over an existing semiconductor manufacturing technology. In the embodiments of the present disclosure, a plurality of mask layers are formed on a surface of a semiconductor substrate based on photolithography patterns of large sizes. The patterns in the plurality of mask layers are properly designed to obtain discrete active areas of small sizes in an array arrangement by using these mask layers. Therefore, the manufacturing difficulty is reduced, and the production capacity and yield of semiconductor structures are improved.

### BRIEF DESCRIPTION OF THE DRAWINGS

FIGs. 1, 2, 3, 4, 5, 6, 7, 8, 9 and 10 are schematic structural diagrams illustrating the implementations of the semiconductor structure manufacturing methods according to embodiments of the present invention.

FIGs. 11, 12, 13, 14, 15, 16, 17 and 18 are schematic top views illustrating the semiconductor structures according to embodiments of the present invention.

Reference numerals:
- A-A1 and B-B1:: Directions;
- 100:: Substrate;
- 110:: First mask layer;
- 120:: Second mask layer;
- 130:: Third mask layer;
- 111:: First pattern;
- 222:: Second pattern;
- 333:: Third pattern;
- 444:: Fourth pattern;
- 555:: Fifth pattern;
- 666:: Sixth pattern;
- 222":: Second complementary pattern;
- 333":: Third complementary pattern;
- 210:: First sacrificial layer;
- 220:: Second sacrifice layer;
- 112:: Isolating layer;
- 223:: Isolating layer;
- 300:: Mask material.

### DETAILED DESCRIPTION OF THE EMBODIMENTS

The following will describe in detail the semiconductor structure and the manufacturing method thereof provided in the present invention in combination with the accompanying drawings and specific embodiments.

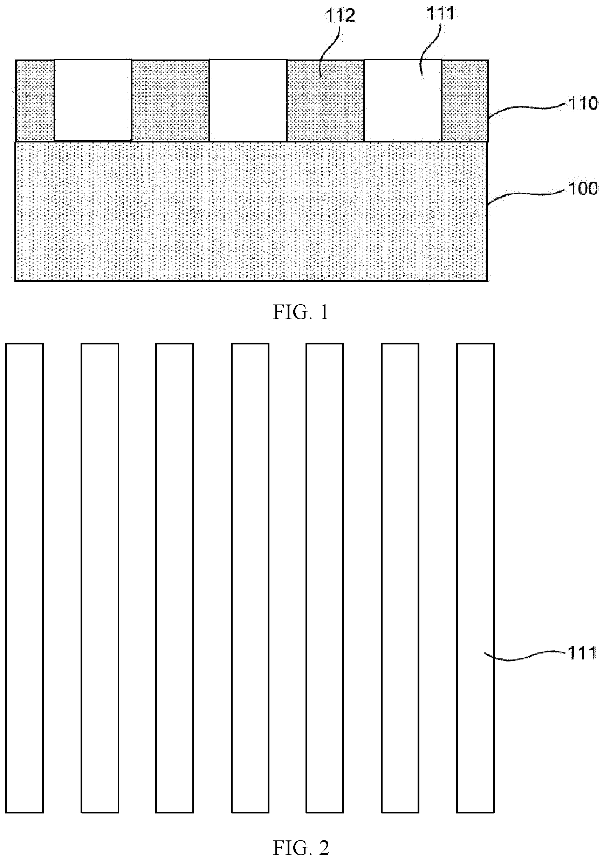

This disclosure provides a semiconductor structure manufacturing method according to the first embodiment of this disclosure, referring to FIGs. 1-10.

Referring to FIG. 1, in the first step, a substrate 100 is provided, in which a first mask layer 110 is formed on the surface of the substrate 100, and a plurality of strip-shaped first patterns 111 arranged in parallel are formed in the first mask layer 110 and are configured to form a plurality of strip-shaped continuous active areas arranged in parallel in the substrate 100. Only three strip-shaped first patterns 111 are schematically depicted in FIG. 1 to show the structure clearly.

Referring to FIG. 2 which is a schematic top view illustrating the strip-shaped first patterns 111, a plurality of strip-shaped first patterns 111 are schematically depicted to clearly show the structure. The first patterns 111 may be rectangles or curved irregular patterns. A pitch between two adjacent first patterns 111 is a preset value ACT.

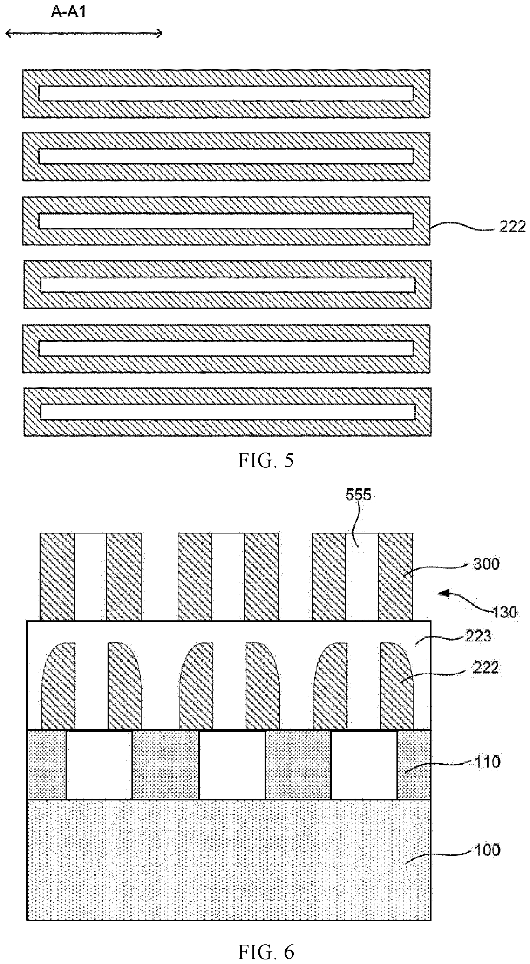

The first patterns 111 may be formed by one photolithography process or by using a self-aligned double patterning (SADP) technology. A person skilled in the art should understand that the first patterns 111 formed by using the SADP technology may be closed patterns, and every two adjacent first patterns 111 may be connected together at the upper and lower edges of the first patterns 111 shown in FIG. 2, similar to the left and right edges in FIG. 5.

The material of the first patterns 111 in the first mask layer 110 may be at least one of silicon nitride, silicon oxynitride, silicon dioxide, polycrystalline silicon, silicon carbide, silicon carbonnitride, and carbon. An isolating layer 112 may be formed at the position of the first mask layer 110 not occupied by the first patterns 111. A material of the isolating layer 112 is different from the material of the first patterns 111. The etching selection ratio of the material of the isolating layer 112 to the material of the first patterns 111 should be enough at least one etching or corrosive condition.

The substrate 100 may include, but not limited to, a monocrystalline silicon substrate, a polycrystalline silicon substrate, a gallium nitride substrate, a silicon-on-insulator substrate, or a sapphire substrate.

When the substrate 100 is a monocrystalline silicon substrate or a polycrystalline silicon substrate, the substrate 100 may be an intrinsic silicon substrate or a doped silicon substrate. Further, the substrate 100 may be an N-type or P-type monocrystalline silicon substrate.

In the second step, a second mask layer 120 is formed on the first mask layer 110, and a plurality of strip-shaped second patterns 222 arranged in parallel are formed in the second mask layer 120.

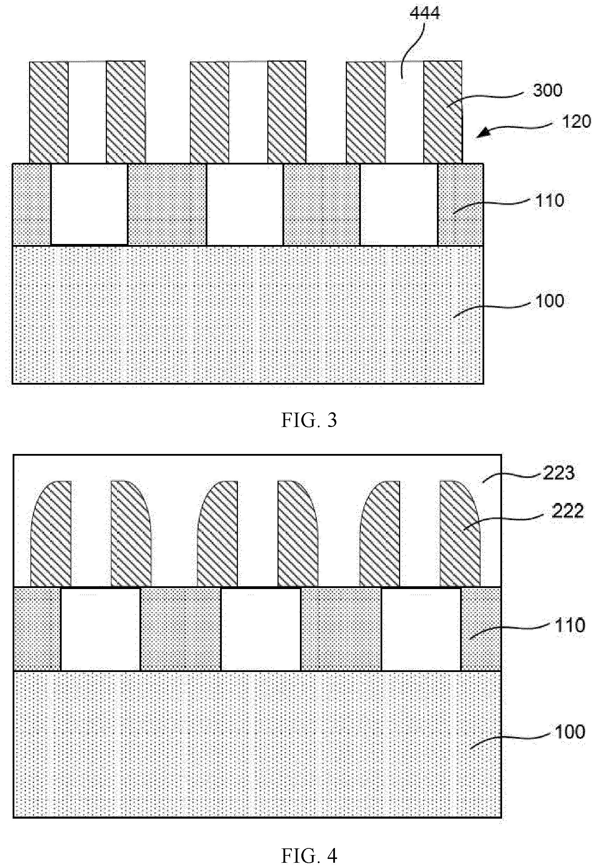

Specifically, forming the second mask layer 120 on the first mask layer 110 includes that a first sacrificial layer 210 is deposited on the surface of the first mask layer 110 by a deposition process, referring to FIG. 3. The first sacrificial layer 210 may be deposited in various manners in this embodiment. For example, the first sacrificial layer 210 with a preset thickness is deposited on the surface of the first mask layer 110 by chemical vapor deposition. Further, by controlling the flow rate of the inlet airflow, the flow quantity of the inlet airflow, the deposition duration, and the deposition temperature, or the like to improve the precision of control for the airflow and temperature, the first sacrificial layer 210 with a uniform thickness on the surface of the first mask layer 110 is be obtained. The material of the first sacrificial layer 210 may include, but not limited to, silicon dioxide, doped silicon dioxide, silicon nitride, silicon oxynitride, polycrystalline silicon, monocrystalline silicon, carbon in this embodiment.

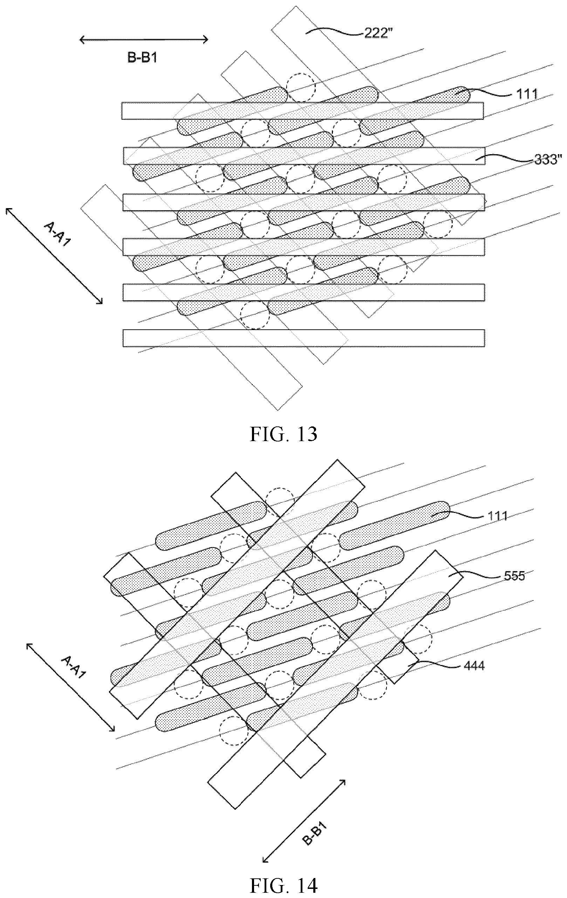

FIG. 14 is a schematic top view illustrating the semiconductor structure in an embodiment. Referring to FIGs. 3 and 14, a plurality of strip-shaped fourth patterns 444 arranged in parallel are be formed in the first sacrificial layer 210. A mask material 300 is formed on the sidewalls of the fourth patterns 444. The mask material 300 may be directly formed on the sidewalls of the fourth patterns 444. Alternatively, the mask material 300 may be firstly deposited on the entire fourth patterns 444, and then be etched to retain only the mask material 300 on the sidewalls of the fourth patterns 444.

Referring to FIG. 4, a plurality of strip-shaped second patterns 222 arranged in parallel is be formed in the second mask layer 120 by removing the first sacrificial layer 210 and while retaining the mask material 300 on the sidewalls of the fourth patterns 444. A schematic top view illustrating the second patterns 222 is shown in FIG. 5. It should be noted that FIG 14 is only to illustrate the positional relationship of the drawings and is not necessarily the actual top view presented in a certain step.

The first sacrificial layer 210 may be removed by a wet etching process or a dry etching process. An appropriate etchant or corrodent should be selected to avoid causing excessive damage to the mask material on the sidewalls when removing the first sacrificial layer 210.

Referring to FIG. 5, the second patterns 222 extend along the direction of A-Al, and the second patterns 222 may be rectangles. Because of the foregoing steps, the edges of every two adjacent second patterns 222 may be connected together. Because the edges eventually will be trimmed, the connection of the edges will not affect the formation of discrete active areas in an array arrangement. It should be noted that the sizes in the drawings are only illustrative, and do not represent the actual ratio.

The second mask layer 120 may include another material other than the material of the second patterns 222 to serve as an isolating layer 223 . The isolating layer 223 may be formed after the formation of the second patterns 222. The top surface of the isolating layer 223 may be flush with the top surface of the second patterns 222, and the isolating layer 223 may only fill the area outside the second patterns 222. Alternatively, the top surface of the isolating layer 223 may be higher than the top surface of the second patterns 222. In other words, the isolating layer 223 fills the area between adjacent second patterns 222 and covers the surfaces of the second patterns 222. The etching selection ratio of the material of the isolating layer 223 to the material of the second patterns 222 is enough under at least one etching or corrosive condition. The isolating layer 223 may include, but not limited to, photoresist, silicon dioxide, doped silicon dioxide, silicon nitride, silicon oxynitride, polycrystalline silicon, monocrystalline silicon, carbon.

In the third step, third mask layer 130 is formed on the second mask layer 120and a plurality of strip-shaped third patterns 333 arranged in parallel are be formed in the third mask layer 130, in which the second patterns 222 overlap with the third patterns 333and the second patterns 222 and the third patterns 333 are configured to cut the first patterns 111 at predetermined positions.

Specifically, forming the third mask layer 130 on the second mask layer 120 includes that a second sacrificial layer 220 is deposited on the surface of the second mask layer 120 by a deposition process, referring to FIG 6 and FIG14 which is a schematic top view of the semiconductor structure in an embodiment. A plurality of strip-shaped fifth patterns 555 arranged in parallel are formed in the second sacrificial layer 220, and a mask material 300 is formed on the sidewalls of the fifth patterns 555. Referring to FIGs. 6, 7 and 14, the second sacrificial layer 220 is removed, while the mask material on the sidewalls of the fifth patterns 555 are retained, so as to form the third mask layer 130. A plurality of strip-shaped third patterns 333 arranged in parallel are formed in the third mask layer 130. It should be noted that the mask material on the sidewall in this third step may be the same as or different from the mask material on the sidewall in the second step, which is not limited herein.

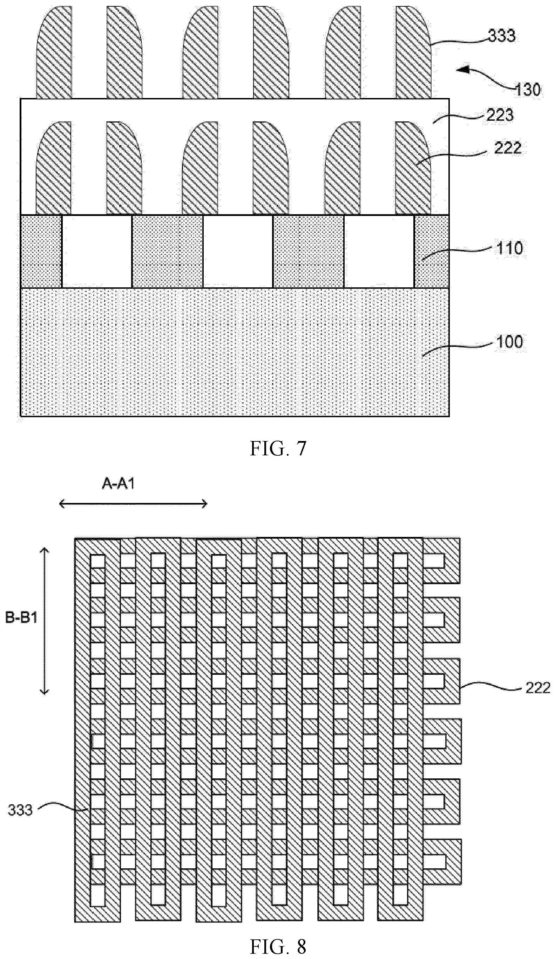

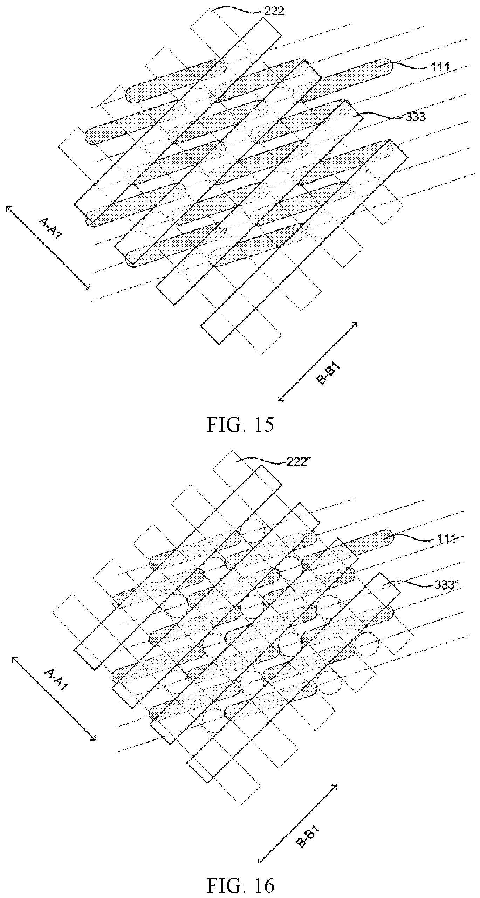

Referring to FIGs. 8 and 15, the second patterns 222 overlap with the third patterns 333. The second patterns 222 and the third patterns 333 are configured to cut the first patterns 111 at predetermined positions. A-A1 is the extension direction of the second patterns 222, and B-B1 is the extension direction of the third patterns 333.

In order to make he subsequently formed discrete active areas have a proper arrangement and thus increase the storage density of a dynamic random access memory, the angle between the second patterns 222 and the first patterns 111 in this embodiment may be set to range from 65 degrees to 75 degrees, or from 68 degrees to 72 degrees, or be set to 70.15 degrees. The angle between the second patterns 222 and the third patterns 333 is set to 90 degrees in this embodiment. The pitch between the two adjacent fourth patterns 444 may be 4 to 5 times, or 4 to 4.5 times, or 4.35 times of the pitch between the two adjacent first patterns 111 (the preset value ACT). The pitch between the two adjacent fifth patterns 555 may be 4 to 5 times, or 4 to 4.5 times, or 4.35 times of the pitch between the two adjacent first patterns 111 (i.e., the preset value ACT).

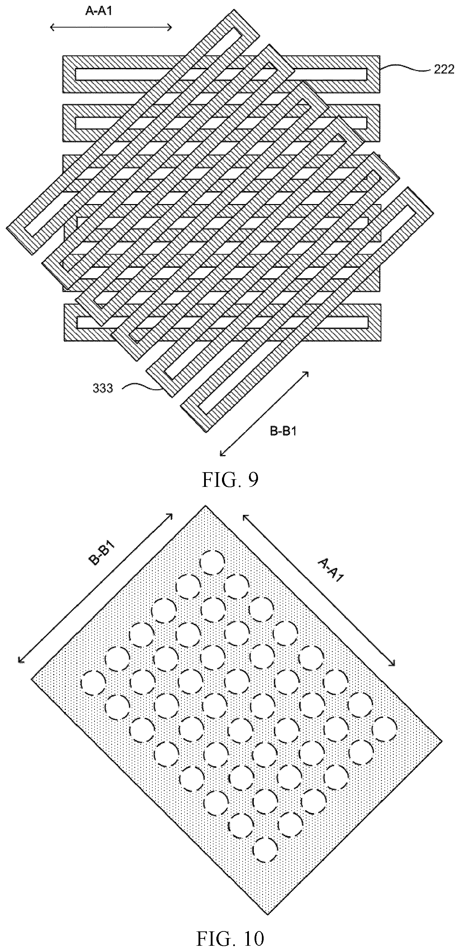

Further, referring to FIGs. 10 and 15, the second patterns 222 and the third patterns 333 are configured to cut the first patterns 111 at predetermined positions by the step which includes utilizing the overlap area of the second patterns 222 and the third patterns 333 to cut the first patterns 111. The dashed circles represent the predetermined positions at which the first patterns 111 are cut by utilizing the overlap area of the second patterns 222 and the third patterns 333. It should be noted that although the predetermined positions shown in FIGs. 10 and 15 are represented by circles, the overlap area of the second patterns 222 and the third patterns 333 is not limited to circles which is only used for illustration. In actual processes, the overlap area may be a circle or an irregular pattern, which is not limited in the embodiments of the disclosure.

Further, the substrate 100 includes an array area, and the first patterns 111, the second patterns 222 and the third patterns 333 are all formed at least in the array area. It should be noted that as FIG. 15 is only a schematic diagram illustrating how to utilize the second patterns 222 and the third patterns 333 to cut the first patterns 111 in the embodiment, the continuity of the continuous strip-shaped first patterns 111 at the predetermined position is not be shown.

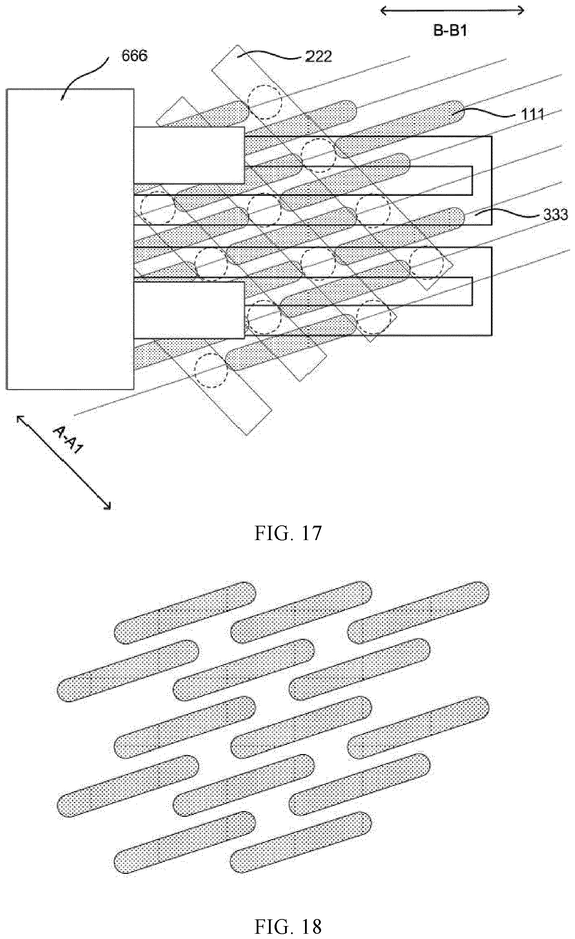

In the fourth step, layer-by-layer etching is performed, using the first mask layer 110, the second mask layer 120, and the third mask layer 130 as masks, to transfer the first patterns 111, the second patterns 222, and the third patterns 333 to the substrate 100 to form a plurality of discrete active areas in an array arrangement, as shown in FIG. 18.

In this embodiment, a plurality of mask layers are formed on the surface of a semiconductor substrate based on photolithography patterns of large sizes. The patterns in the plurality of mask layers may be properly designed to obtain discrete active areas of small sizes in an array arrangement by using these mask layers with proper patterns. Therefore, the manufacturing difficulty is reduced, and the production capacity and yield of semiconductor structures are improved.

In this specification, the photolithography patterns of large sizes refer to patterns with a relatively large pitch, which are easy to be made, and the patterns of small sizes refer to patterns with a relatively small pitch, which are relatively difficult to be made.

The second embodiment of this disclosure provides a semiconductor structure manufacturing method.

Referring to FIG. 1, in the first step, a substrate 100 is provided, in which a first mask layer 110 is formed on the surface of the substrate 100, and a plurality of strip-shaped first patterns 111 arranged in parallel are formed in the first mask layer 110 and are configured to form a plurality of strip-shaped continuous active areas arranged in parallel in the substrate 100.

Referring to FIG. 2 which is a schematic top view illustrating the strip-shaped first patterns 111, a plurality of strip-shaped first patterns 111 are schematically depicted to clearly show the structure. The first patterns 111 may be rectangles or curved irregular patterns. The pitch between two adjacent first patterns 111 is a preset value ACT.

The first patterns 111 may be formed by one photolithography process or by using an SADP technology. A person skilled in the art should understand that the first patterns 111 formed by using the SADP technology may be closed patterns, and every two adjacent first patterns 111 may be connected together at the upper and lower edges of the first patterns 111 shown in FIG. 2, similar to the left and right edges in FIG. 5.

In the second step, a second mask layer 120 is formed on the first mask layer 110 and a plurality of strip-shaped second patterns 222 arranged in parallel are formed in the second mask layer 120.

Specifically, forming the second mask layer 120 on the first mask layer 110 includes that a first sacrificial layer 210 is deposited on the surface of the first mask layer 110 by a deposition process, referring to FIG. 3.

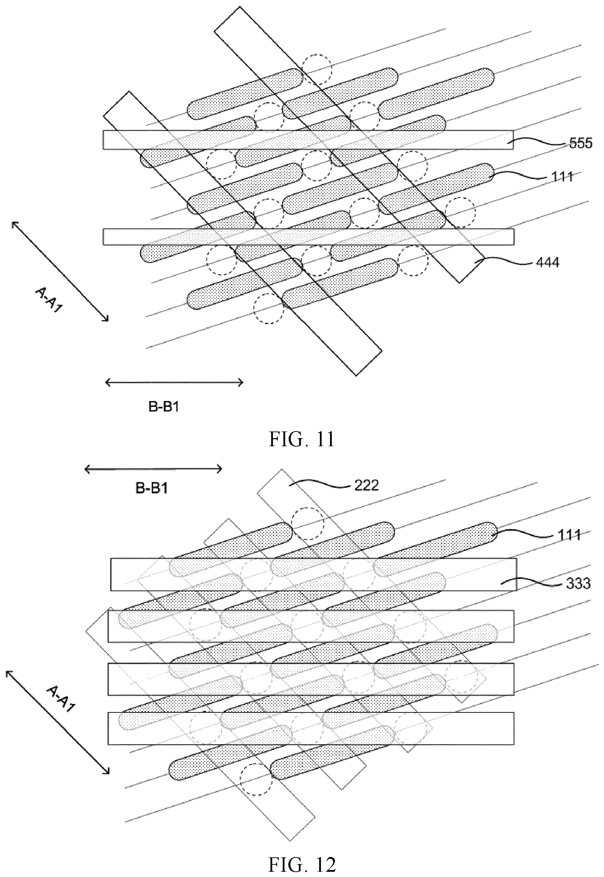

Referring to FIG. 3 and FIG. 11 which is a schematic top view illustrating the semiconductor structure in the second embodiment, a plurality of strip-shaped fourth patterns 444 arranged in parallel are formed in the first sacrificial layer 210. A mask material 300 is formed on the sidewalls of the fourth patterns 444. The mask material 300 may be directly formed on the sidewalls of the fourth patterns 444. Alternatively, the mask material may be firstly deposited on the entire fourth patterns 444, and then be etched to retain only the mask material 300 on the sidewalls of the fourth patterns 444. Referring to FIG. 4, the plurality of strip-shaped second patterns 222 arranged in parallel in the second mask layer 120 are formed by removing the first sacrificial layer 210and while retaining the mask material 300 on the sidewalls of the fourth patterns 444. A schematic top view illustrating the second patterns 222 is shown in FIG. 5. It should be noted that FIG 11 is only to illustrate the positional relationship of the drawings and is not necessarily the actual top view presented in a certain step.

In the third step, a third mask layer 130 is formed on the second mask layer 120, and a plurality of strip-shaped third patterns 333 arranged in parallel are formed in the third mask layer 130, in which, the second patterns 222 overlap with the third patterns 333 and the second patterns 222 and the third patterns 333 are configured to cut the first patterns 111 at predetermined positions.

Specifically, forming the third mask layer 130 on the second mask layer 120 includes a second sacrificial layer 220 is deposited on the surface of the second mask layer 120 by a deposition process, referring to FIG. 6, and FIGs.11 and 12 which are a schematic top view of the semiconductor structure in the embodiment. A plurality of strip-shaped fifth patterns 555 arranged in parallel are formed in the second sacrificial layer 220, and a mask material 300 is formed on the sidewalls of the fifth patterns 555. Referring to FIGs. 6, 7, and 12, the third mask layer 130 is formed by removing the second sacrificial layer 220 and while retaining the mask material on the sidewalls of the fifth patterns 555. The plurality of strip-shaped third patterns 333 arranged in parallel are formed in the third mask layer 130. The mask material on the sidewalls in this third step may be the same as or different from the mask material on the sidewalls in the second step, which is not limited herein.

Referring to FIGs. 9 and 12, the second patterns 222 overlap with the third patterns 333. The second patterns 222 and the third patterns 333 are configured to cut the first patterns 111 at predetermined positions. A-A1 is an extension direction of the second patterns 222, and B-B1 is an extension direction of the third patterns 333.

Specifically, To properly arrange the subsequently formed discrete active areas and to increase the storage density of a dynamic random access memory, the angle between the second patterns 222 and the first patterns 111 in this embodiment may be set to range from 65 degrees to 75 degrees, or from 68 degrees to 72 degrees, or be set to 70.15 degrees. The angle between the second patterns 222 and the third patterns 333 may be set to range from 45 degrees to 55 degrees, or from 48 degrees to 52 degrees, or be set to 49.1 degrees. The pitch between the fourth patterns 444 arranged in parallel is 4 to 5 times, or 4 to 4.5 times, or 4.25 times of the pitch between the two adjacent first patterns 111 (the preset value ACT). The pitch between the plurality of the fifth patterns 555 arranged in parallel is 3 to 4 times, or 3 to 3.5 times, or 3.21 times of the pitch between the two adjacent first patterns 111 (the preset value ACT).

Further, the second patterns 222 and the third patterns 333 are configured to cut the first patterns 111 at predetermined positions, by a step which includes utilizing the overlap area of the second patterns 222 and the third patterns 333 to cut the first patterns 111. Referring to FIGs. 10 and 12, the dashed circles represent the predetermined positions at which the first patterns 111 are cut by the overlap area of the second patterns 222 and the third patterns 333. It should be noted that although the predetermined positions shown in FIGs. 10 and 12 are represented by circles, the overlap area of the second patterns 222 and the third patterns 333 is not limited to circles which is used for illustration. In the actual processes, the overlap area may be a circle or an irregular pattern, which is not limited in the embodiments of the disclosure.

Further, the substrate 100 includes an array area, and the first patterns 111, the second patterns 222 and the third patterns 333 are all formed at least in the array area. It should be noted that as FIG. 12 is only a schematic diagram illustrating how to utilize the second patterns 222 and the third patterns 333 to cut the first patterns 111 in an embodiment, the continuity of the continuous strip-shaped first patterns 111 at the predetermined position is not be shown.

The above first to third steps in the second embodiment has the same process as that in the corresponding steps of the first embodiment. Therefore, the same details of these steps are omitted herein based on the foregoing.

In the fourth step, layer-by-layer etching is performed, using the first mask layer 110, the second mask layer 120, and the third mask layer 130 as masks, to transfer the first patterns 111, the second patterns 222, and the third patterns 333 to the substrate 100 to form a plurality of discrete active areas in an array arrangement, as shown in FIG. 18.

The second embodiment differs from the first embodiment in that the angle between the second patterns 222 and the third patterns 333 is different. The angle may be set by a person skilled in the art based on actual needs, and this embodiment shall not be construed as a limitation.

In the second embodiment, a plurality of mask layers are formed on the surface of a semiconductor substrate based on photolithography patterns of large sizes. The patterns in the plurality of mask layers are properly designed to obtain discrete active areas of small sizes in an array arrangement by using these mask layers with proper patterns. Therefore, the manufacturing difficulty is reduced, and the production capacity and yield of semiconductor structures are improved. The large size and the small size have the same meanings as described omitted herein based on.

The third embodiment of this disclosure provides another semiconductor structure manufacturing method.

Referring to FIG. 1, in the first step, a substrate 100 is provided, in which a first mask layer 110 is formed on the surface of the substrate 100, and a plurality of strip-shaped first patterns 111 arranged in parallel are formed in the first mask layer 110 and are configured to form a plurality of strip-shaped continuous active areas arranged in parallel in the substrate 100.

Referring to FIG. 2 which is a schematic top view illustrating the strip-shaped first patterns 111, a plurality of strip-shaped first patterns 111 are schematically depicted to clearly show the structure.

In the second step, referring to FIG. 3, a second mask layer 120 is formed on the first mask layer 110. A plurality of strip-shaped second patterns 222 arranged in parallel are formed in the second mask layer 120.

Specifically, forming the second mask layer 120 on the first mask layer 110 includes that a first sacrificial layer 210 is deposited on the surface of the first mask layer 110 by a deposition process, referring to FIG. 3.

Referring to FIG. 3 and FIG. 14, which is a schematic top view illustrating the semiconductor structure in the second embodiment, a plurality of strip-shaped fourth patterns 444 arranged in parallel are formed in the first sacrificial layer 210.

A mask material 300 is formed on the sidewalls of the fourth patterns 444. The mask material 300 may be directly formed on the sidewalls of the fourth patterns 444. Alternatively, the mask material may be firstly deposited on the entire fourth patterns 444, and then be etched to retain only the mask material 300 on the sidewalls of the fourth patterns 444.

Referring to FIG. 4, the plurality of strip-shaped second patterns 222 arranged in parallel in the second mask layer 120 are formed by removing the first sacrificial layer 210 and while retaining the mask material 300 on the sidewalls of the fourth patterns 444. A schematic top view illustrating the second patterns 222 is shown in FIG. 5. It should be noted that FIG 14 is only to illustrate the positional relationship of the drawings and is not necessarily the actual top view presented in a certain step.

In the third step, a third mask layer 130 is formed on the second mask layer 120, and a plurality of strip-shaped third patterns 333 arranged in parallel are formed in the third mask layer 130, in which the second patterns 222 overlap with the third patterns 333and the second patterns 222 and the third patterns 333 are configured to cut the first patterns 111 at predetermined positions.

FIG. 14 is a schematic top view illustrating the semiconductor structure in this embodiment. Referring to FIGs. 6 and 14, Specifically, forming the third mask layer 130 on the second mask layer 120 includes a second sacrificial layer 220 is deposited on the surface of the second mask layer 120 by a deposition process, referring to FIG. 6 and FIG. 14 which is a schematic top view of the semiconductor structure in the embodiment. A plurality of strip-shaped fifth patterns 555 arranged in parallel are formed in the second sacrificial layer 220, and a mask material 300 is formed on the sidewalls of the fifth patterns 555.

Referring to FIGs. 6, 7, and 14, the third mask layer 130 is formed by removing the second sacrificial layer 220 and while retaining the mask material on the sidewall of the fifth patterns 555. The plurality of strip-shaped third patterns 333 arranged in parallel are formed in the third mask layer 130. The mask material on the sidewalls in the third step may be the same as or different from the mask material on the sidewalls in the second step, which is not limited herein.

Referring to FIG. 8, the second patterns 222 overlap with the third patterns 333. The second patterns 222 and the third patterns 333 are configured to cut the first patterns 111 at predetermined positions. A-A1 is the extension direction of the second patterns 222, and B-B1 may be the extension direction of the third patterns 333.

Specifically, in order to make the subsequently formed discrete active areas arrange properly and thus increase the storage density of a dynamic random access memory, the angle between the second patterns 222 and the first patterns 111 in this embodiment may be set to range from 65 degrees to 75 degrees, or from 68 degrees to 72 degrees, or be set to 70.15 degrees. The angle between the second patterns 222 and the third patterns 333 is set to 90 degrees. The pitch between the two adjacent fourth patterns 444 is 4 to 5 times, or 4 to 4.5 times, or 4.25 times of the pitch between the two adjacent first patterns 111 (the preset value ACT). The pitch between the two adjacent fifth patterns 555 is 4 to 5 times, or 4 to 4.5 times, or 4.25 times of the between of the two adjacent first patterns 111 (i.e., the preset value ACT).

Further, the second patterns 222 and the third patterns 333 are configured to cut the first patterns 111 at predetermined positions by the steps as the followings. Referring to FIG.16, a second complementary mask layer (not shown in the drawings) is formed by utilizing the second patterns 222 on the second mask layer 120, in which the second complementary mask layer has the second complementary patterns 222" covering the area outside the second patterns 222. A third complementary mask layer (not shown in the drawings) is formed by utilizing the third patterns 333 on the third mask layer 130, in which the third complementary mask layer has the third complementary patterns 333" covering the area outside the third patterns 333. The first patterns 111 are cut by utilizing the non-overlapping area of the second complementary patterns 222" and the third complementary patterns 333". The dashed circles represent the predetermined positions at which the first patterns 111 are cut by the overlapping area of the second complementary patterns 222" and the third complementary patterns 333". Although the predetermined positions depicted in FIGs. 10 and 16 are represented by circles, the overlapping area of the second complementary patterns 222" and the third complementary patterns 333" is not limited to circles which are only used for illustration. In actual processes, the overlapping area may be a circle or an irregular pattern, which is not limited in this disclosure.

Further, the substrate 100 includes an array area, and the first patterns 111, the second complementary patterns 222", and the third complementary patterns 333" are all formed at least in the array area. It should be noted that as FIG. 16 is only a schematic diagram illustrating how to utilize the second patterns 222 and the third patterns 333 to cut the first patterns 111in an embodiment, the continuity of continuous strip-shaped first patterns 111 at the predetermined position is not be shown.

The above first to third steps in this third embodiment has the same process as that in the corresponding steps in the foregoing embodiments. Therefore, the same details of these steps are omitted herein based on the foregoing process.

In the fourth step, layer-by-layer etching is performed, using the first mask layer 110, the second mask layer 120, and the third mask layer 130 as masks, to transfer the first patterns 111, the second complementary patterns 222", and the third complementary patterns 333" to the substrate 100 to form a plurality of discrete active areas in an array arrangement, as shown in FIG. 18.

The third embodiment differs from the first embodiment in that, in the third embodiment, the first patterns 111 are cut by utilizing the non-overlapping area of the second complementary patterns 222" and the third complementary patterns 333". The non-overlapping area may be set by a person skilled in the art based on actual needs, and this embodiment shall not be construed as a limitation.

In this embodiment, a plurality of mask layers are formed on a surface of a semiconductor substrate based on photolithography patterns of large sizes. The patterns in the plurality of mask layers are properly designed to obtain discrete active areas of small sizes in an array arrangement by using these mask layers with proper patterns. Therefore, the manufacturing difficulty is reduced, and the production capacity and yield of semiconductor structures are improved.

The fourth embodiment of this disclosure provides another semiconductor structure manufacturing method.

Referring to FIG. 1, in the first step, a substrate 100 is provided, in which a first mask layer 110 is formed on the surface of the substrate 100, and a plurality of strip-shaped first patterns 111 arranged in parallel are formed in the first mask layer 110 and are configured to form a plurality of strip-shaped continuous active areas arranged in parallel in the substrate 100.

Referring to FIG. 2 which is a schematic top view illustrating the strip-shaped first patterns 111, a plurality of strip-shaped first patterns 111 are schematically depicted to clearly show the structure. The first patterns 111 may be rectangles or curved irregular patterns. The pitch between the two adjacent first patterns 111 is a preset value ACT. The first patterns 111 may be formed by one photolithography process or by using an SADP technology. A person skilled in the art should understand that the first patterns 111 formed by using the SADP technology may be closed patterns, and every two adjacent first patterns 111 may be connected together at the upper and lower edges of the first patterns 111 shown in FIG. 2, similar to the left and right edges in FIG. 5.

In the second step, referring to FIG. 3, a second mask layer 120 is formed on the first mask layer 110 and a plurality of strip-shaped second patterns 222 arranged in parallel are formed in the second mask layer 120.

Specifically, forming the second mask layer 120 on the first mask layer 110 includes that a first sacrificial layer 210 is deposited on the surface of the first mask layer 110 by a deposition process, referring to FIG. 3.

Referring to FIG. 3 and FIG. 11 which is a schematic top view illustrating the semiconductor structure in this embodiment, a plurality of strip-shaped fourth patterns 444 arranged in parallel are formed in the first sacrificial layer 210.

A mask material 300 is formed on the sidewalls of the fourth patterns 444. The mask material 300 may be directly formed on the sidewalls of the fourth patterns 444. Alternatively, the mask material may be firstly deposited on the entire fourth patterns 444, and then be etched to retain only the mask material 300 on the sidewalls of the fourth patterns 444. Referring to FIG. 4, the plurality of strip-shaped second patterns 222 arranged in parallel are formed in the second mask layer 120 by removing the first sacrificial layer 210 while retaining the mask material 300 on the sidewalls of the fourth patterns 444. A schematic top view illustrating the second patterns 222 is shown in FIG. 5. It should be noted that FIG 11 is only to illustrate the positional relationship of the drawings and is not necessarily the actual top view presented in a certain step.

In the third step, a third mask layer 130 is formed on the second mask layer 120 and a plurality of strip-shaped third patterns 333 arranged in parallel are formed in the third mask layer 130, in which the second patterns 222 overlap with the third patterns 333 and the second patterns 222 and the third patterns 333 are configured to cut the first patterns 111 at predetermined positions.

Specifically, forming the third mask layer 130 on the second mask layer 120 includes a second sacrificial layer 220 is deposited on the surface of the second mask layer 120 by a deposition process, referring to FIG. 6, and FIGs.11 and 12 which are a schematic top view of the semiconductor structure in the embodiment. A plurality of strip-shaped fifth patterns 555 arranged in parallel are formed in the second sacrificial layer 220, and a mask material 300 is formed on the sidewalls of the fifth patterns 555. Referring to FIGs. 6, 7 and 12, the third mask layer 130 is formed by removing the second sacrificial layer 220 and while retaining the mask material on the sidewalls of the fifth patterns 555. The plurality of strip-shaped third patterns 333 arranged in parallel are formed in the third mask layer 130. The mask material on the sidewalls in the third step may be the same as or different from the mask material on the sidewalls in the second step, which is not limited herein.

Referring to FIG. 9, the second patterns 222 overlap with the third patterns 333, and the second patterns 222 and the third patterns 333 are configured to cut the first patterns 111 at predetermined positions. A-A1 is an extension direction of the second patterns 222, and B-B1 is an extension direction of the third patterns 333.

Specifically, to properly arrange the subsequently formed discrete active areas and thus increase the storage density of a dynamic random access memory, the angle between the second patterns 222 and the first patterns 111 is set to range from 65 degrees to 75 degrees, or from 68 degrees to 72 degrees, or be set to 70.15 degrees. The angle between the second patterns 222 and the third patterns 333 is set to range from 45 degrees to 55 degrees or from 48 degrees to 52 degrees, or be set to 49.1 degrees. The pitch between the fourth patterns 444 arranged in parallel is 4 to 5 times, or 4 to 4.5 times, or 4.25 times of the pitch between the two adjacent first patterns 111 (the preset value ACT). The pitch between the fifth patterns 555 arranged in parallel is 3 to 4 times, or 3 to 3.5 times, or 3.21 times of the pitch between the two adjacent first patterns 111 (the preset value ACT).

Further, the second patterns 222 and the third patterns 333 are configured to cut the first patterns 111 at predetermined positions, which further includes includes the following actions. Referring to FIG. 13, a second complementary mask layer (not shown in the drawing) is formed by utilizing the second patterns 222 on the second mask layer 120, in which the second complementary mask layer has the second complementary patterns 222" covering the area outside the second patterns 222. A third complementary mask layer (not shown in the drawings) is formed by utilizing the third patterns 333 on the third mask layer 130, in which the third complementary mask layer has the third complementary patterns 333" covering the area outside the third patterns 333. The first patterns 111 are cut by utilizing the non-overlapping area of the second complementary patterns 222" and the third complementary patterns 333". Referring to FIGs. 10 and 13, the dashed circles represent the predetermined positions at which the first patterns 111 are cut by the overlapping area of the second complementary patterns 222" and the third complementary patterns 333". Although the predetermined positions depicted in FIGs. 10 and 13 are represented by circles, the overlapping area of the second complementary patterns 222" and the third complementary patterns 333" is not limited to circles which are only used for illustration. In actual processes, the overlapping area may be a circle or an irregular pattern, which is not limited in the embodiment of the disclosure. Further, the substrate 100 includes an array area, and the first patterns 111, the second complementary patterns 222", and the third complementary patterns 333" are all formed at least in the array area.

The first through third steps in the fourth embodiment may be the same as the corresponding steps in the foregoing embodiments. Therefore, the details of the same steps are omitted herein for the sake of conciseness.

In the fourth step, layer-by-layer etching is performed, using the first mask layer 110, the second mask layer 120, and the third mask layer 130 as masks, to transfer the first patterns 111, the second complementary patterns 222", and the third complementary patterns 333" to the substrate 100 to form a plurality of discrete active areas in an array arrangement, as shown in FIG. 18.

The fourth embodiment differs from the first embodiment in that the angle between the second patterns 222 and the third patterns 333 is different, and the first patterns 111 are cut by utilizing the non-overlapping area of the second complementary patterns 222" and the third complementary patterns 333", which may be set based on actual needs, and this embodiment shall not be construed as a limitation.

In this embodiment, a plurality of mask layers are formed on a surface of a semiconductor substrate based on photolithography patterns of large sizes. The patterns in the plurality of mask layers are properly designed to obtain discrete active areas of small sizes in an array arrangement by using these mask layers with proper patterns. Therefore, the manufacturing difficulty is reduced, and the production capacity and yield of semiconductor structures are improved.

The fifth embodiment of this disclosure provides another semiconductor structure manufacturing method.

In the first step, referring to FIG. 1, a substrate 100 is provided, in which a first mask layer 110 is formed on the surface of the substrate 100, and a plurality of strip-shaped first patterns 111 arranged in parallel are formed in the first mask layer 110 and are configured to form a plurality of strip-shaped continuous active areas arranged in parallel in the substrate 100.

Referring to FIG. 2 which is a schematic top view illustrating the strip-shaped first patterns 111, a plurality of strip-shaped first patterns 111 are schematically depicted to clearly show the structure. The first patterns 111 may be rectangles or curved irregular patterns. The pitch between the two adjacent first patterns 111 is a preset value ACT.

The first patterns 111 may be formed by one photolithography process or by using an SADP technology. A person skilled in the art should understand that the first patterns 111 formed by using the SADP technology may be closed patterns, and every two first patterns 111 shown in FIG. 2 may be connected together at the upper and lower edges of the first patterns 111, similar to the left and right edges in FIG. 5.

In the second step, a second mask layer 120 is formed on the first mask layer 110 and a plurality of strip-shaped second patterns 222 arranged in parallel are formed in the second mask layer 120.

Specifically, forming the second mask layer 120 on the first mask layer 110 includes that a first sacrificial layer 210 is deposited on the surface of the first mask layer 110 by a deposition process, referring to FIG. 3.

Referring to FIG. 3 and FIG. 11 which is a schematic top view illustrating the semiconductor structure in this embodiment, a plurality of strip-shaped fourth patterns 444 arranged in parallel are formed in the first sacrificial layer 210. A mask material 300 is formed on the sidewalls of the fourth patterns 444. The mask material 300 may be directly formed on the sidewalls of the fourth patterns 444. Alternatively, the mask material may be firstly deposited on the entire fourth patterns 444, and then be etched to retain only the mask material 300 on the sidewalls of the fourth patterns 444. Referring to FIG. 4, the plurality of strip-shaped second patterns 222 arranged in parallel are formed in the second mask layer 120 by removing the first sacrificial layer 210 while retaining the mask material 300 on the sidewalls of the fourth patterns 444. A schematic top view illustrating the second patterns 222 is shown in FIG. 5. It should be noted that

FIG 11 is only to illustrate the positional relationship of the drawings and is not necessarily the actual top view presented in a certain step.

In the third step, a third mask layer 130 is formed on the second mask layer 120 a plurality of strip-shaped third patterns 333 arranged in parallel are formed in the third mask layer 130, in which the second patterns 222 overlap with the third patterns 333and the second patterns 222 and the third patterns 333 are configured to cut the first patterns 111 at predetermined positions.

Specifically, forming the third mask layer 130 on the second mask layer 120 includes a second sacrificial layer 220 is deposited on the surface of the second mask layer 120 by a deposition process, referring to FIG. 6, and FIGs.11 and 12 which are a schematic top view of the semiconductor structure in the embodiment. A plurality of strip-shaped fifth patterns 555 arranged in parallel are formed in the second sacrificial layer 220, and a mask material 300 is formed on the sidewalls of the fifth patterns 555.Referring to FIGs. 6, 7 and 12, the third mask layer 130 is formed by removing the second sacrificial layer 220 while retaining the mask material on the sidewalls of the fifth patterns 555. The plurality of strip-shaped third patterns 333 arranged in parallel are formed in the third mask layer 130. The mask material on the sidewalls in the third step may be the same as or different from the mask material on the sidewalls in the second step, which is not limited herein.

Referring to FIG. 9, the second patterns 222 overlap with the third patterns 333, and the second patterns 222 and the third patterns 333 are configured to cut the first patterns 111 at predetermined positions. A-A1 may be an extension direction of the second patterns 222, and B-B1 is an extension direction of the third patterns 333. Specially, in order to make the subsequently formed discrete active areas arrange properly and thus increase the storage density of a dynamic random access memory, the angle between the second patterns 222 and the first patterns 111 is set to range from 65 degrees to 75 degrees, or from 68 degrees to 72 degrees, or be set to 70.15 degrees. The angle between the second patterns 222 and the third patterns 333 is set to range from 45 degrees to 55 degrees or from 48 degrees to 52 degrees, or be set to 49.1 degrees. The pitch between the fourth patterns 444 arranged in parallel is 4 to 5 times, or 4 to 4.5 times, or 4.25 times of the pitch between the two adjacent first patterns 111 (the preset value ACT). The pitch between the fifth patterns 555 arranged in parallel may be 3 to 4 times, or 3 to 3.5 times, or 3.21 times of the pitch between the two adjacent first patterns 111 (he preset value ACT).

Further, the second patterns 222 and the third patterns 333 are configured to cut the first patterns 111 at predetermined positions by the step which includes utilizing the overlap area of the second patterns 222 and the third patterns 333 to cut the first patterns 11. Referring to FIGs. 10 and 12, the dashed circles represent the predetermined positions at which the first patterns 111 are cut by utilizing the overlap area of the second patterns 222 and the third patterns 333. Although the predetermined positions depicted in FIGs. 10 and 12 are represented by circles, the overlap area of the second patterns 222 and the third patterns 333 is not limited to circles which are only used for illustration. In actual processes, the overlap area may be a circle or an irregular pattern, which is not limited in the embodiment of the disclosure.

Further, the substrate 100 includes an array area, and the first patterns 111, the second patterns 222, and the third patterns 333 are all formed at least in the array area. It should be noted that as FIG. 12 is only a schematic diagram illustrating how to utilize the second patterns 222 and the third patterns 333 to cut the first patterns 111 in the embodiment, the continuity of the continuous strip-shaped first patterns 111 at the predetermined position is not shown.

The first to third step in the fifth embodiments has the same process as that in the corresponding steps in the foregoing embodiments. Therefore, the same details of these steps are omitted herein based on the foregoing process.

In the fourth step, referring to FIG. 17, a fourth mask layer is formed on the third mask layer. Sixth patterns 666 covering at least a portion of the second patterns 222 and at least a portion of the third patterns 333 at the edge of the array area is formed in the fourth mask layer.

In the fifth step, the sixth patterns 666 further cover at least secondary active areas (not shown in the drawings) at the ends of continuous active areas at the edge of the array area. The secondary active areas have a length less than that of discrete active areas. The first mask layer 110, the second mask layer 120, the third mask layer 130, and the fourth mask layer are used as masks to transfer the first patterns 111, the second patterns 222, the third patterns 333, and the sixth patterns 666 to the substrate to form discrete active areas in an array arrangement, in which the secondary active areas are not provided at the edge of the array area, as shown in FIG. 18.

The fifth embodiment differs from the foregoing embodiments in that the fourth mask layer is formed to trim incomplete discrete active areas at the edge of the array area, to alleviate manufacturing issues that may be caused by defective active areas at the edge. Although the first mask layer, the second mask layer, and the third mask layer in this embodiment are the same as those in a foregoing embodiment, a person skilled in the art should understand that the fourth mask layer formed in this embodiment may be applied to the first embodiment, the second embodiment, the third embodiment, and the fourth embodiment, and the details of the same steps are omitted. A person skilled in the art may choose, according to actual needs, whether to trim active areas at the edge of the array area after the discrete active areas in an array arrangement are formed.

In the fifth embodiment, defective active areas in the array area is trimmed to further improve the reliability and the performance of the semiconductor structure and to improve the yield.

The second embodiment, the third embodiment, the fourth embodiment, and the fifth embodiment of the present disclosure are described relatively briefly as they share some common contents with the first embodiment. Relevant descriptions in the first embodiments may be referred to for details.

An embodiment of the disclosure further provides a semiconductor structure.

Referring to FIG. 18, the semiconductor structure includes a substrate and discrete active areas.

A plurality of discrete active areas in an array arrangement are formed in the substrate.

The discrete active areas are formed by using the semiconductor structure manufacturing method in any one of the foregoing embodiments..

In this embodiment, a plurality of mask layers are formed on the surface of the semiconductor substrate. The patterns in the plurality of mask layers are properly designed to obtain an array of discrete active areas of small sizes in an array arrangement by using these mask layers.

Referring to FIG. 18, a plurality of strip-shaped active areas arranged in parallel are cut to form discrete active areas. Referring to FIG. 10, the dashed circles represent the predetermined positions at which the first patterns are cut by utilizing the overlap area of the second patterns and the third patterns. Although the predetermined positions depicted in FIG. 10 are represented by circles, the overlap area of the second patterns and the third patterns is not limited to circles which are only used for illustration. In actual manufacturing processes, the overlap area may be a circle or an irregular pattern, which is not limited in this disclosure.

The previous descriptions are some embodiments of the present invention. A person of ordinary skills in the art can make improvements or refinements without departing from the principle of the present invention. The improvements and refinements shall be regarded as falling within the protection scope of the present invention.

## Claims

1. A semiconductor structure manufacturing method, **characterized in that**, the method comprises:
providing a substrate, in which a first mask layer is formed on the substrate, a plurality of strip-shaped first patterns arranged in parallel are formed in the first mask layer and are configured to form a plurality of strip-shaped continuous active areas arranged in parallel in the substrate;
forming a second mask layer on the first mask layer, in which a plurality of strip-shaped second patterns arranged in parallel are formed in the second mask layer;
forming a third mask layer on the second mask layer, in which a plurality of strip-shaped third patterns arranged in parallel are formed in the third mask layer, and the second patterns and the third patterns overlap and are configured to cut the first patterns at predetermined positions; and
performing layer-by-layer etching, using the first mask layer, the second mask layer, and the third mask layer as masks, to transfer the first patterns, the second patterns and the third patterns to the substrate to form a plurality of discrete active areas in an array arrangement.

2. The semiconductor structure manufacturing method of claim 1, wherein forming the second mask layer on the first mask layer, in which a plurality of strip-shaped second patterns arranged in parallel are formed, comprises:
forming a first sacrificial layer on the first mask layer, in which a plurality of strip-shaped fourth patterns arranged in parallel are formed in the first sacrificial layer;
forming a mask material on a sidewall of the fourth patterns; and
removing the first sacrificial layer while retaining the mask material on the sidewall of the fourth patterns to form the second mask layer.

3. The semiconductor structure manufacturing method of claim 2, wherein forming a third mask layer on the second mask layer, in which a plurality of strip-shaped third patterns arranged in parallel are formed, comprises:
forming a second sacrificial layer on the second mask layer, in which a plurality of strip-shaped fifth patterns arranged in parallel are formed in the second sacrificial layer;
forming a mask material on a sidewall of the fifth patterns; and
removing the second sacrificial layer while retaining the mask material on the sidewall of the fifth patterns to form the third mask layer.

4. The semiconductor structure manufacturing method of claim 3, wherein an angle between the second patterns and the first patterns is in a range of 65 degrees to 75 degrees.

5. The semiconductor structure manufacturing method of claim 4, wherein an angle between the second patterns and the third patterns is 90 degrees.

6. The semiconductor structure manufacturing method of claim 5, wherein a pitch between the fourth patterns arranged in parallel is 4 to 5 times of a pitch between the first patterns arranged in parallel, and a pitch between the fifth patterns arranged in parallel is 4 to 5 times between the pitch of the first patterns arranged in parallel.

7. The semiconductor structure manufacturing method of claim 4, wherein an angle between the second patterns and the third patterns is in a range of 45 degrees to 55 degrees.

8. The semiconductor structure manufacturing method of claim 7, wherein a pitch of the fourth patterns arranged in parallel is 4 to 5 times between a pitch between the first patterns arranged in parallel, and a pitch between the fifth patterns arranged in parallel is 3 to 4 times of the pitch between the first patterns arranged in parallel.

9. The semiconductor structure manufacturing method of claim 1, wherein the second patterns and the third patterns are configured to cut the first patterns at predetermined positions by a step which comprises utilizing an overlap area of the second patterns and the third patterns to cut the first patterns.

10. The semiconductor structure manufacturing method of claim 1, wherein the second patterns and the third patterns are configured to cut the first patterns at the predetermined positions by steps which comprise:
forming a second complementary mask layer by utilizing the second patterns in the second mask layer, in which second complementary patterns covering an area outside the second patterns are formed in the second complementary mask layer ;
forming a third complementary mask layer by utilizing the second patterns in the third mask layer, in which third complementary patterns covering an area outside the third patterns are formed in the third complementary mask layer; and
cutting the first patterns by utilizing a non-overlapping area of the second complementary patterns and the third complementary patterns.

11. The semiconductor structure manufacturing method of claim 1, wherein the substrate comprises an array area, and the first patterns, the second patterns and the third patterns are all formed at least in the array area.

12. The semiconductor structure manufacturing method of claim 10, further comprising:
forming a fourth mask layer on the third mask layer, in which sixth patterns covering at least a portion of the second patterns and at least a portion of the third patterns at an edge of the array area is formed in the fourth mask layer.

13. The semiconductor structure manufacturing method of claim 10, wherein the sixth patterns further covers at least secondary active areas at ends of the continuous active areas at an edge of the array area, in which the secondary active areas have a length less than that of the discrete active areas, and
the first patterns, the second patterns, the third patterns and the sixth patterns are transferred to the substrate to form the discrete active areas in an array arrangement by using the first mask layer, the second mask layer, the third mask layer and the fourth mask layer as masks, in which the secondary active areas are not provided at the edge of the array area.

14. The semiconductor structure manufacturing method of claim 1, wherein the first patterns are formed by using a self-aligned double patterning technology.

15. The semiconductor structure manufacturing method of claim 10, wherein the array area is a storage array area of a dynamic random access memory.

16. The semiconductor structure manufacturing method of claim 1, wherein a material of the mask layers comprises at least one of silicon dioxide, silicon nitride, silicon oxynitride, polycrystalline silicon, monocrystalline silicon and carbon.

17. A semiconductor structure, **characterized in that** the semiconductor structure comprises:
a substrate, in which discrete active areas in an array arrangement are formed in the substrate based on the semiconductor structure manufacturing method according to claim 1.
